Europäisches Patentamt

European Patent Office

Office européen des brevets

(19)

(11) Publication number: **0 148 361**
**A1**

(12)

# EUROPEAN PATENT APPLICATION

(21) Application number: **84113396.0**

(22) Date of filing: **07.11.84**

(51) Int. Cl.⁴: **H 01 L 41/04**

(30) Priority: **14.11.83 US 551452**

(43) Date of publication of application: **17.07.85**
**Bulletin 85/29**

(84) Designated Contracting States: **DE FR GB IT NL**

(71) Applicant: **GENERAL ELECTRIC COMPANY, 1 River Road, Schenectady New York 12305 (US)**

(72) Inventor: **Burman, Orvar Boson, 3923 Princeton Boulevard, South Euclid Ohio 44121 (US)**
Inventor: **Davenport, John Martin, 5128 Edenhurst Avenue, Lyndhurst Ohio 44124 (US)**

(74) Representative: **Schüler, Horst, Dr. et al, Kaiserstrasse 41, D-6000 Frankfurt/Main 1 (DE)**

(54) **Piezoceramic transformer device.**

(57) Novel mounting means are described for a piezoceramic transformer device to avoid spurious responses occurring when the piezoceramic member is acted upon by external mechanical forces or other influences. More particularly, the output AC signal derived from said device is most sensitive to device operation at or near its resonant frequency and any external mechanical forces which can accidently impinge upon the piezoceramic member in said device will substantially vary the desired resonant frequency operation and the attendant output AC signal derived therefrom. The present mounting means for said device mechanically isolates said piezoceramic member in a housing with novel suspension means.

PIEZOCERAMIC TRANSFORMER DEVICE

BACKGROUND OF THE INVENTION

The concept of a piezoceramic transformer device is well known wherein an input AC signal at a predetermined voltage is generally applied to the primary electrodes of a piezoceramic member in order to generate an output AC signal at the secondary electrodes of said member at a different voltage generally higher in value. It is also well known that efficient operation of said device is highly dependent upon the operation at or near the resonant frequency of said piezoceramic member and that said resonant frequency operation can be disturbed by mechanical forces of a spurious nature acting upon this device. While shock resistant mounting of the piezoceramic member in this device is also known as a means to ameliorate the general problem, known mounting constructions still permit the piezoceramic member in the device to respond excessively to external shocks, vibrations, and other external influences.

SUMMARY OF THE INVENTION

It is now been discovered by the present applicants that the piezoceramic member in this type device can be more effectively isolated from extraneous mechanical forces by freely suspending said member in a housing while further providing said member with a particular type of electrical connection being made thereto. Specifically, said improved piezoceramic transformer device utilizes a piezoceramic member of planar configuration having identical pairs of electrode regions disposed on each major surface, elongated compliant conductor elements being secured at one end to each of said electrode regions while being connected at the opposite ends to terminals for said electrode elements, said terminal elements being mounted in a housing totally enveloping said piezoceramic member, and said piezoceramic member being suspended within said housing solely by the compliant conductor elements so as to avoid physical contact with said housing. By physically suspending the piezoceramic member within a totally enclosed housing in this manner, it is also possible to dampen mechanical forces transmitted to said member by including a gaseous atmosphere, such as air, in the housing. While said further benefit does not require that the piezoceramic member be hermetically sealed within the housing package, said enclosure should preclude ambient moisture from depositing on the piezoceramic member since moisture may result in electrical shorting between the electrode elements especially with high output voltage devices.

In one preferred embodiment, the presently improved device utilizes a planar piezoceramic member producing an output AC signal in a medium frequency range from about 25 kiloherz (kHz) to about 500 kiloherz (kHz) which further includes two identical pairs of metalized electrode regions disposed on the major surfaces and covering a substantial surface area, each of said electrode regions also being spaced apart on the same surface by an electrically insulating region and being cooperatively associated as a first pair of opposing surface electrodes to apply an input AC signal of predetermined voltage across a first cross-sectional region of said piezoceramic member located between said first pair of opposing surface electrodes in order to derive an output AC signal of different voltage in a second cross-sectional region of said piezoceramic member located between a second pair of opposing surface electrodes, each elongated compliant metal conductor element being connected at one end to one of said electrode regions and all said conductor elements being connected to separate terminal elements projecting inwardly from the same wall member of a box-like housing that totally encloses both piezoceramic member and said conductor elements, and with said piezoceramic member being suspended within said housing solely by the conductor elements so as to avoid physical contact with said housing and minimize variation in the output AC signal attributable to external mechanical forces acting upon said piezoceramic member. A dielectric surface layer of lesser thickness can also be deposited on each major surface of said piezoceramic member, such as a spray coating of an organic polymer material, in order to help maintain electrical isolation between electrode regions on each major surface of said piezoceramic member. By "compliant" conductor elements as mentioned in the present specification is meant a resilient electrically conductive material, such as copper or aluminum metal wire, having small enough dimensions and mass with respect to the dimensions of the supported piezoceramic member not to dynamically load said piezoceramic member when acted upon by mechanical forces being transmitted from the housing. The applied AC signal to said preferred type device can be intermittent, such as a pulse or pulse train, in order to derive a pulsed output signal such as derived with other signal transformers. In one such type device constructed with a thin (.006 inch thickness) rectangular sheet of a known lead zirconate titanate ceramic material having dimensions of 1.5 times 2 centimeters in surface area there was obtained a fully developed output signal responsive to said applied AC signal in less than 100 microseconds. Alternately, said transformer device can be driven continuously with an applied AC signal at constant input frequency to provide a steady state mode of operation producing a relatively constant level AC output signal.

The limited physical and electrical connection means being provided is critical for mechanical isolation of the piezoceramic member from transient external shocks and vibration acting upon the housing package. The compliant nature of said elongated conductor elements permits mechanical forces to be dampened or absorbed largely within these elements rather than being transferred to the piezoceramic member as would be the case with rigid connections. By further limiting the cross-section and mass of said compliant conductor elements to strictly that needed for mechanical suspension of said piezoceramic member, it can be appreciated that little appreciable dynamic loading or damping of said member will result from external shocks, vibration and other external influences. Additionally, it can be appreciated that said elongated compliant conductor elements are joined only at the ends to the electrode regions in the aforementioned preferred embodiment, thereby further limiting transfer of mechanical shocks and vibration from the housing package to the piezoceramic member suspended therein solely by said connection means. If greater mechanical stiffness for the piezoceramic member suspension proves desirable in a particular design package, however, such can also be provided with supplemental compliant support elements, such as springs, which contact said piezoceramic member at locations of minimum displacement.

A suitable housing member for use in the present device should be rigid in construction and provide transient thermal as well as mechanical isolation for the enclosed piezoceramic member. A dielectric material, for said member such as plastic, further provides electrical isolation of the enclosed electrical parts and can be molded as an integral container by conventional means. Additionally, such molded housing member can also be provided with stand-off support means for mounting to a printed circuit board as well as given hinge and lock means permitting test or repair of the enclosed parts. Such molded plastic housing member further enables a header means to be included for assembly of terminal elements thereto and with said terminal elements optionally having the pin configuration and spacing suitable for mounting to a printed circuit board. Still further, the housing member can be encapsulated such as by potting without affecting performance of the enclosed piezoceramic member. While conventional means such as soldering can be employed to secure one end of the elongated conductor elements to the piezoceramic member, elevated temperatures may cause localized depolarization of the ceramic material. Ultrasonic welding or some other joining technique which minimizes heating of the ceramic can ameliorate this difficulty.

Suitable ceramic materials for construction of the present piezoceramic member are well known such as lead zirconate titanate, barium titanate or modifications thereof and can be generally further characterized in terms of other already known electrical parameters including Curie temperature, electromechanical coupling factor, and resonant frequency. The preferred ceramic in the present device has been found to be lead zirconate titanate by reason of its low mechanical losses, low power requirements, good piezoelectric characteristics, compositional reliability, and low cost. An especially preferred ceramic material of this type is $Pb_{.9812} La_{.0063} (Zr_{.5500} Ti_{.4500})_{.9813} Nb_{.0187} O_3$ which exhibits a Curie temperature of at least 300°C along with an electro-mechanical coupling factor of at least 0.5 extending over the temperature range -40 to 125°C. The square of the electromechanical coupling factor is defined as the ratio of the decimal equivalents of the mechanical to electrical energy in each half cycle of device operation. As such, the coupling may vary from zero to unity. For a transformer, the coupling has added significance since the coupling occurs first in converting the input electrical energy into mechanical energy and again in bringing the mechanical energy out as a useful electrical response. Methods to fabricate the piezoceramic member as a thin layer sheet useful in a planar mode of operation device are also well known and can proceed by initially depositing said layer from a liquid suspension of the ceramic particulates and finally sintering said ceramic layer, all in a conventional manner.

DECRIPTION OF THE ACCOMPANYING DRAWING

The accompanying drawing represents a perspective view of a representative piezoceramic transformer device embodying the novel mounting means.

DESCRIPTION OF THE PREFERRED EMBODIMENTS

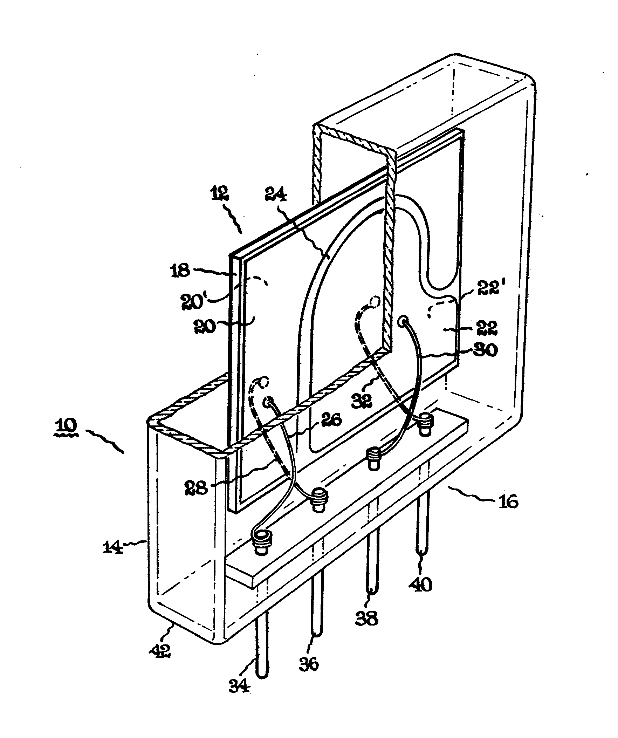

In Fig. 1, is shown in perspective view a piezoceramic device 10 comprising a planar piezoceramic member 12 being physically suspended within a housing package 14 solely by a novel support construction 16. Said planar piezoceramic member 12 comprises a thin layer of lead zirconate titanate ceramic 18 having an identical pair of electrode regions 20-20' and 22-22' is disposed on each major surface of said ceramic layer and which are spaced apart by an electrically insulating region 24 of the ceramic material.  The novel mount construction 16 for said piezoceramic member 12 consists of 4 elongated compliant metal conductor elements 26-32 which are secured at one end to each of the electrode regions while being secured at the opposite ends to separate terminal elements 34-40, respectively, said terminal elements being secured to and projecting inwarding from one wall 42 of the housing member 14.  As can be noted, said housing package member 14 comprises a box-like enclosure which totally envelops the piezoceramic member but is spaced apart therefrom so as to avoid physical contact when assembled together in the final device.  As can be further noted from the drawing, said first pair of compliant metal conductor elements 26-28 provide means to apply an input AC signal at a predetermined voltage to a first pair of opposing surface electrode regions 20-20' while the remaining pair of elongated compliant metal conductors 30 and 32 serve as a means to retrieve an output AC signal at the second pair of opposing surface electrodes 22-22'.  It can also be noted that said second pair of electrodes being used as the transformer secondary have been located in the central region of the piezoceramic member where the piezoelectric response is greatest.

In operation, said piezoceramic member 12 vibrates at or near resonant frequency responsive to

- 8 -                                        LD 9152

the applied AC signal at a predetermined voltage and proper frequency to generate an output AC signal at the second pair of opposing electrodes responsive to said vibration. Electrical isolation exists between the major surfaces of said member when properly insulated and which can be enhanced by depositing a thin surface dielectric coating on the metalized surfaces. The application of such dielectric coating over the surface of the ceramic member can prevent flash-over at high operating voltages. Since performance of the transformer device deteriorates rapidly for small departures (as little as 2%) from the resonant frequency operation, as previously indicated, the present packaging and suspension means for the piezoceramic member in said device not only minimizes its physical contact with the external environment but further minimizes the effect of transient temperature changes which can also vary the resonant frequency. The relatively small mass of the elongated compliant conductor elements being employed in the present device still further minimizes departure of the piezoceramic member from resonant frequency operation. Accordingly, the major improvement represented in the present invention resides in the combined effect of having the piezoceramic member freely suspended within a total enclosure while further minimizing any adverse impact which the electrical connections made to said member can have with respect to the mechanical coupling factor of device operation. In the latter regard, it should also be noted that effective mechanical decoupling of said elongated conductor elements in the above illustrated preferred embodiment has been provided simply by utilizing a compliant configuration wherein the mass of said elements is dictated primarily by the mechanical support needed for suspension of the piezoceramic member since the electrical current carrying capability of electrical connections in this type transformer device is minimal.

It will be apparent from the foregoing description that various modifications can be made in the presently improved device which is still within the spirit and scope of the present invention. For example, it is contemplated to still further modify the shape of the above illustrated housing package dependent upon the shape of the piezoceramic member to be enclosed along with modifying the electrical termination means used for the compliant electrical connection made thereto. Still other modifications to the primary and secondary electrode configurations of the piezoceramic member than above specifically described are also contemplated. Both multiple primary and secondary surface electrodes can be employed and wherein the primary pairs of opposing surface electrodes will generally be located at peripheral surfaces while the secondary pairs of opposing surface electrodes will generally be located in a central surface area where the piezoelectric effect is greatest. It is thereby intended to limit the present invention, therefore, only by the scope of the following claims:

CLAIMS

1. A piezoceramic transformer device which comprises a planar piezoceramic member having identical pairs of electrode regions disposed on the major surfaces, elongated compliant conductor elements being secured at one end to each of said electrode regions while being secured at the opposite ends to terminals for said electrode regions, said terminal elements being mounted in a housing totally enveloping said piezoceramic member, and said piezoceramic member being suspended within said housing by the compliant conductor elements so as to avoid physical contact with said housing.

2. A device as in claim 1 wherein said housing member has a box-like configuration with said terminal elements projecting inwardly from a wall member of said box-like member.

3. A device as in claim wherein said housing member also contains a gaseous atmosphere.

4. A device as in claim 1 wherein the electrode regions disposed on each major surface of said piezoceramic member cover a substantial surface area and with the electrode regions on the same surface being spaced apart by an electrically insulating region.

5. A device as in claim 1 wherein said identical pairs of electrode regions comprise a first pair of opposing surface electrodes to apply an input AC signal of predetermined voltage across a first cross-sectional region of said piezoceramic member located between said first pair of opposing surface electrodes in order to derive an output AC signal of different voltage in a second cross-sectional region of said piezoceramic member located between a second pair of opposing surface electrodes.

6. A device as in claim 5 wherein the input AC signal drives the piezoceramic member at its resonant frequency.

7. A device as in claim 5 wherein a continuous AC signal is applied to said first pair of opposing surface electrodes.

8. A device as in claim 5 wherein said AC signal applied to said first pair of opposing surface electrodes is a pulse.

9. A device as in claim 1 which further includes a dielectric surface layer deposited on each major surface of said piezoceramic member.

10. A piezoceramic transformer device which comprises a planar piezoceramic member adapted to produce an output AC signal at a medium frequency range from about 25kHz to about 500kHz having two identical pairs of metalized electrode regions disposed on the major surfaces and covering a substantial surface area, each of said electrode regions being spaced apart on the same surface by an electrically insulating region and being cooperatively associated as a first pair of opposing surface electrodes to apply an input AC signal of predetermined voltage across a first cross-sectional region of said piezoceramic member located between said first pair of opposing surface electrodes in order to derive an output AC signal of different voltage in a second cross-sectional region of said piezoceramic member located between a second pair of opposing surface electrodes, each elongated compliant metal conductor element being secured at one end to one of said electrode regions and all said conductor elements being secured at the opposite ends to separate terminal elements, said terminal elements all projecting inwardly from the same wall member of a box-like housing totally enclosing said piezoceramic member and said conductor elements, and with said piezoceramic member being suspended within said housing by the compliant metal conductor elements so as to avoid physical contact with said housing and minimize variation in the output AC signal attributable to external mechanical forces acting upon said piezoceramic member.

11. A device as in claim 10 wherein said housing further contains a gaseous atmosphere.

12. A device as in claim 10 which further includes a relatively thin dielectric surface layer deposited on each major surface of said piezoceramic member.

13. A device as in claim 12 wherein said dielectric surface layer is a coating of an organic polymer material.

14. A device as in claim 10 wherein said piezoceramic member comprises a thin layer of lead zirconate titanate ceramic material including modifications thereof.

15. A device as in claim 11 wherein said gaseous atmosphere is air.

16. A device as in claim 14 having an electromechanical coupling factor of at least 0.5

17. A device as in claim 14 having a Curie temperature of at least 300°C.

18. A device as in claim 14 wherein said ceramic material is $Pb_{.9812} La_{.0063} (Zr_{.5500} Ti_{.4500})_{.9813} Nb_{.0187} O_3$.

European Patent
Office

EUROPEAN SEARCH REPORT

0148361
Application number

EP 84 11 3396

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 069 434 (M. KAWAI et al.)<br>* Column 2, lines 25-33; figure 1 * | 1,2 | H 01 L 41/04 |
| A | US-A-3 909 641 (Y. OHSHIMA et al.)<br>* Claim 1; figures 1A,3 * | 4,5 | |
| A | DE-A-2 537 361 (SOCIETE SUISSE POUR l'INDUSTRIE HORLOGERE)<br>* Page 2, figure 1 * | 1 | |
| A | ELECTRONICS INTERNATIONAL, vol. 55, no. 6, March 24, 1982, New York, USA; J. GOSCH "Power coupler uses piezoelectric ceramic", pages 74,76<br>* Whole article * | 4 | TECHNICAL FIELDS SEARCHED (Int. Cl.4) |
| A | US-A-4 017 752 (S. KAKEHI et al.)<br>* Claim 1; column 2, lines 28 - 43; column 4, lines 16-56; figures 1d,2h,3d,5d,6e,8d * | 1,2,13 ,14 | H 01 L 41/00<br>H 02 M 5/04<br>H 04 N 3/18 |

The present search report has been drawn up for all claims

| Place of search | Date of completion of the search | Examiner |
|---|---|---|
| BERLIN | 07-02-1985 | ROTHER A H J |